# EUROPEAN PATENT APPLICATION

(11) **EP 2 151 509 A1**
(43) Date of publication of application: **10.02.2010**
(21) Application number: 08161747.4
(22) Date of filing: 04.08.2008
(51) Int. Cl.: C23C 16/455, H01J 37/32

(54) **Reactive gas distributor, reactive gas treatment system, and reactive gas treatment method**

(71) Applicant: Applied Materials, Inc., Santa Clara, CA 95054 (US)
(72) Inventor: Dieguez-Campo, Manuel, 63457 Hanau (DE); Lopp, Andreas, 63579 Freigericht (DE); Gertmann, Reiner, 63589 Linsengericht (DE)
(74) Representative: Zimmermann & Partner

(57) **Abstract**

A reactive gas distributor for a reactive gas treatment system is provided, comprising a housing, a reactive gas inlet provided at one side of the housing and fluidly connectable to a remote plasma source, and a plurality of reactive gas outlets at another side of the housing and arranged in a pattern.

## Description

### FIELD OF THE INVENTION

The invention generally relates to a reactive gas distributor, a reactive gas treatment system, a reactive gas treatment method, a use of a reactive gas distributor, and a use of a reactive gas treatment system. More particularly, it relates to a reactive gas distributor for a reactive gas treatment system, a reactive gas treatment system, a reactive gas treatment method for treating a substrate with a reactive gas, a use of a reactive gas distributor in a coating apparatus for the production of OLED devices, and a use of a reactive gas treatment system in a coating apparatus for the production of OLED devices.

### BACKGROUND OF THE INVENTION

Treating substrates with reactive gases, e.g. etching processes, are generally utilized for delivering high concentrations of reactive gas species to enable advanced process applications, such as wafer pre-clean, photo-resist strip, and thin film deposition. In such reactive gas treatment processes, a process gas is typically activated in a remote chamber distant from a process chamber in which the reactive gas treatment of a substrate is to be performed. Such an activation may be carried out e.g. in a remote plasma source, in order to produce a reactive gas for treating the substrate to be processed. Examples of remotely produced reactive gases are based on process gases containing NF₃ and/or O₂. After activation, the reactive gas is then passed into a process chamber in which the substrates are processed. Remote production of the reactive gas provides specific benefits over other reactive gas processes, such as providing the activated species of the reactive gas without any temperature rise in the process chamber or enabling a directed flow of the reactive gas towards a particular surface of a substrate to be treated.

A specific application of remote plasma sources is in the production of Organic Light-Emitting Diodes (OLED). OLEDs are a special type of light-emitting diodes in which the emissive layer comprises a thin film of certain organic compounds. Such systems can be used in television screens, computer displays, portable system screens, and so on. OLEDs can also be used for general space illumination. The range of colors, brightness, and viewing angle possible with OLED displays are greater than that of traditional LCD displays because OLED pixels directly emit light and do not require a back light. Therefore, the energy consumption of OLED displays is considerably less than that of traditional LCD displays. Further, the fact that OLEDs can be printed onto flexible substrates opens the door to new applications such as roll-up displays or even displays embedded in clothing.

OLEDs are typically formed of multiple layers of materials, some of them including organic compounds, on a substrate. When a current is passed through the multiple layers of organic materials, light is emitted. The color of light is dependent on the type of materials.

Hence, OLEDs are typically manufactured by depositing and treating multiple layers of materials, including organic layers, on a pre-cleaned substrate. In multi-color OLED devices, for example, an organic hole-injecting and hole-transporting layer and a pattern of one or more organic light-emitting layers may be formed between first and second electrodes. For depositing the layers on the substrate, vapor sources, for instance physical vapor deposition (PVD) sources and/or specific organic vapor sources, and precision shadow masks temporarily fixed in relation to the substrate of the OLED device may be used. Color pixelation of OLED displays may be achieved by multiple shadow mask-substrate alignments and vapor depositions. During such vapor depositions, vapor material is typically deposited also on the shadow masks.

Consequently, a typical example of an OLED manufacturing method may include the following steps: at least one step of pre-cleaning the substrate, one or more vapor deposition steps some or each performed using a shadow mask and a source of organic material, and one or more steps of after-treatment of the substrate by etching. Furthermore, a routine procedure of cleaning the shadow masks may be required.

Previously, OLED substrates were usually pre-cleaned using Ar/O₂ mixtures in vacuo and linear ion sources or using ozone in ambient atmosphere. However, during such a pre-treatment the substrates may be unintentionally contaminated with iron. Alternatively, in an OLED manufacturing site, the pre- and after-treatment of the substrates and the cleaning of the shadow masks may be performed using a remote plasma source, for instance by etching with reactive gases. A remote plasma source used for such treatment or etching procedures is typically connected via a flange to a vacuum process chamber in which the pre- and after-treatment of the substrates or the cleaning of the shadow masks is performed. Hence, there is a short distance between the remote plasma source and the substrate, in order to avoid additional surfaces at which the reactive species of the reactive gas may recombine or react, and in order to prevent a reduction of the effectivity of the remote plasma source. However, when using such a configuration, the substrate or mask to be treated by the reactive gas may be not treated or etched uniformly, resulting in OLEDs showing an inhomogeneous performance or resulting in excessively etched or treated parts of the substrate or mask.

### SUMMARY OF THE INVENTION

In light of the above, the reactive gas distributor according to claim 1, the reactive gas treatment system according to claim 8, the reactive gas treatment method according to claim 12, the use of a reactive gas distributor according to claims 15, and the use of a reactive gas treatment system according to claim 16 are provided.

According to one embodiment, a reactive gas distributor for a reactive gas treatment system comprises a housing, a reactive gas inlet provided at one side of the housing and fluidly connectable to a remote plasma source, and a plurality of reactive gas outlets at another side of the housing and arranged in a pattern.

In a further embodiment, a reactive gas treatment system comprises a reactive gas treatment chamber, a reactive gas distributor and a remote plasma source, the reactive gas distributor being provided at the reactive gas treatment chamber, the reactive gas distributor comprising a housing, a reactive gas inlet provided at one side of the housing and fluidly connected to the remote plasma source, and a plurality of reactive gas outlets at another side of the housing and arranged in a pattern.

According to an additional embodiment, a reactive gas treatment method for treating a substrate with a reactive gas comprises providing a substrate in a reactive gas treatment chamber, providing a reactive gas in a remote plasma source, directing the reactive gas through a reactive gas distributor into the reactive gas treatment chamber, the reactive gas distributor having a plurality of reactive gas outlets arranged in a pattern, and treating the substrate with the reactive gas.

According to another embodiment, a use of a reactive gas distributor according to above one embodiment in a coating apparatus for the production of OLED devices is provided.

In a yet further embodiment, a use of a reactive gas treatment system according to above further embodiment in a coating apparatus for the production of OLED devices is provided.

Further aspects, features, and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features of the present invention can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments with reference to the following drawings in which:

Fig. 1 shows a cross-sectional view of an example of a reactive gas treatment system according to embodiments disclosed herein.

Fig. 2 illustrates an enlarged cross-sectional view of an example of a reactive gas distributor according to embodiments disclosed herein.

Fig. 3 shows a side view of the reactive gas distributor illustrated in Fig. 2.

Fig. 4 is a side view of an example of another reactive gas distributor according to embodiments disclosed herein.

Fig. 5 shows a cross-sectional view of an example of another reactive gas treatment system according to embodiments disclosed herein.

Fig. 6 illustrates an enlarged cross-sectional view of an example of a reactive gas distributor according to embodiments disclosed herein.

Fig. 7 shows a side view of the reactive gas distributor illustrated in Fig. 6.

Fig. 8 is a side view of an example of another reactive gas distributor according to embodiments disclosed herein.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope of the present application, the following description is directed to a reactive gas distributor, a reactive gas treatment system, and a reactive gas treatment method used in etching processes, e.g. during manufacture of OLED devices. However, other applications of the devices and methods described herein may be contemplated, e.g. wafer pre-clean, photo-resist strip, and thin film deposition, in particular chemically treating, doping or etching of substrates, such as wafers and semiconductor devices.

Within the following description of the drawings, the same reference numbers refer to the same components. Generally, only the differences with respect to the individual embodiments are described.

In one example of embodiments disclosed herein a reactive gas treatment system is provided, comprising a reactive gas treatment chamber, a reactive gas distributor and a remote plasma source, the reactive gas distributor being provided at the reactive gas treatment chamber, the reactive gas distributor comprising: a housing, a reactive gas inlet provided at one side of the housing and fluidly connected to the remote plasma source, and a plurality of reactive gas outlets at another side of the housing and arranged in a pattern. Moreover, in a variation of this example, the housing of the reactive gas distributor may be provided outside of the reactive gas treatment chamber at an opening of the reactive gas treatment chamber, the reactive gas outlets being directed into the reactive gas treatment chamber. The reactive gas treatment chamber according to embodiments described herein may further comprise a substrate support adapted to stationary provide the substrate to be etched in the reactive gas treatment chamber.

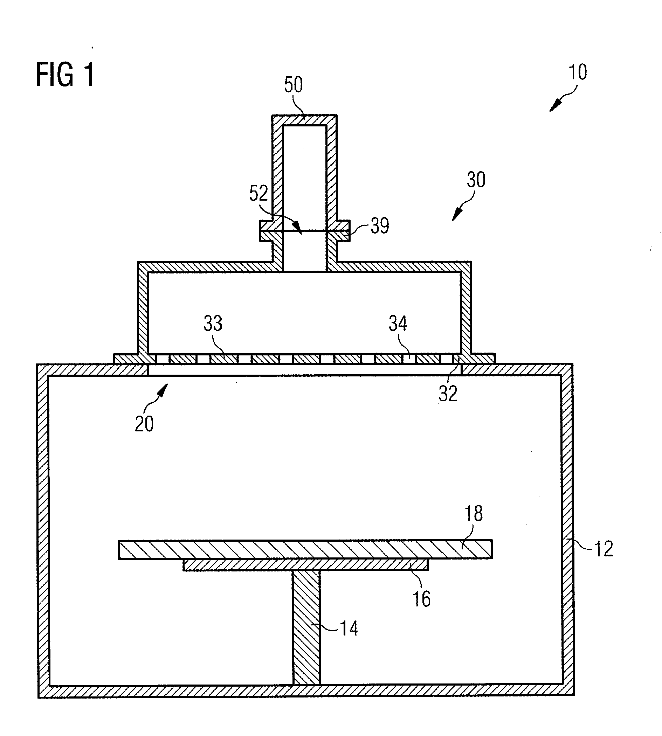

Fig. 1 shows schematically a cross-sectional view of an example of a reactive gas treatment system 10 according to embodiments disclosed herein. The reactive gas treatment system 10 typically includes a vacuum chamber 12 as a reactive gas treatment chamber, which is formed of stainless steel and has a substrate support 14. In the present example, the substrate support 14 may include a horizontal platform 16 for stationary supporting a substrate 18 to be processed. In a variation of this example and of other examples of embodiments disclosed herein, the reactive gas treatment system may include a vacuum chamber and a substrate support, both adapted to support the substrate vertically.

The vacuum chamber 12 is further provided with process gas inlets (not shown), a substrate feeding and discharge aperture (not shown), and vacuum pumps (not shown) for establishing an appropriate gas and/or vacuum atmosphere for the processes to be performed therein. Suitable vacuum pressures for reactive gas etching may for example be in the range of about 0.1 to about 5 mbar, typically about 1 mbar.

Moreover, the vacuum chamber 12 of the present example typically includes an opening 20 facing the horizontal platform 16 of the substrate support 14. The opening 20 may be formed e.g. as a flange or an aperture adapted to receive a unit having a vacuum device for substrate processing integrated. In the present example, the dimensions of the opening 20 are typically smaller than the substrate dimensions. Alternatively, the dimensions of the opening 20 may substantially correspond to or even be greater than the dimensions of the substrate 18 to be treated. A typical example of dimensions of a substrate which may be processed in the reactive gas treatment system of the present example is typically about 750 mm x about 920 mm, more typically about 300 mm x 400 mm. Hence, the dimensions of the opening 20 may be about 750 x 920 mm², and may typically be about 300 x 400 mm². Therefore, the dimensions of the opening 20 may be in a range of about 750 x 920 mm² to about 300 x 400 mm². As will be understood by the skilled person, the dimensions of the vacuum chamber 10 and of opening 20 may be adapted to the dimensions of the substrates to be processed therein.

According to one example of embodiments disclosed herein, a reactive gas distributor for a reactive gas treatment system may comprise: a housing, a reactive gas inlet provided at one side of the housing and fluidly connectable to a remote plasma source, and a plurality of reactive gas outlets at another side of the housing and arranged in a pattern.

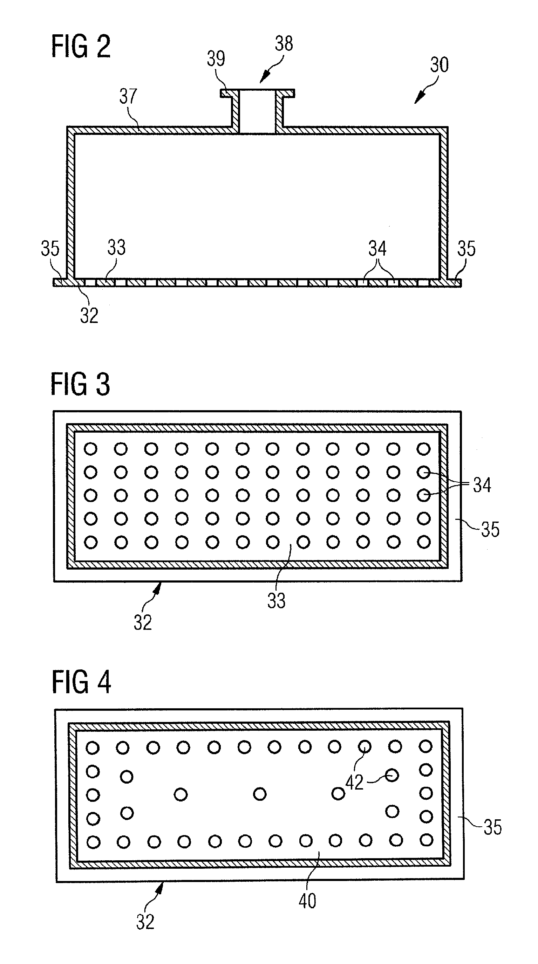

In the present example of a reactive gas treatment system according to embodiments disclosed herein, at opening 20, typically, a reactive gas distributor 30 is mounted in a vacuum-tight way. Fig. 2 is an enlarged cross-sectional view of the reactive gas distributor 30 shown in Fig. 1. Reactive gas distributor 30 is typically formed as a pre-chamber including a housing having six walls. Wall 32 of the reactive gas distributor 30 may include a distribution plate 33 having a plurality of apertures 34 as reactive gas outlets. Further, the wall 32 may be surrounded by a vacuum-tight sealing 35, such as a rectangular vacuum flange. Wall 37 of the reactive gas distributor 30, which is in the present example opposite to the wall 32, includes an opening 38. In the present example, opening 38 is circular and enclosed by a vacuum flange 39, thereby forming the reactive gas inlet.

The dimensions of the reactive gas distributor 30 may be such that the dimensions of the distribution plate 33 contained in wall 32 correspond to the dimensions of the opening 20 provided in the reactive gas treatment system 10, e.g. according to a typical example about 750 x 920 mm², more typically about 300 x 400 mm². Hence, the dimensions of the distribution plate 33 may be in a range of about 750 x 920 mm² to about 300 x 400 mm².

Fig. 3 shows schematically a side view of the reactive gas distributor 30 according to the present example, illustrating a plan view of wall 32 including the distribution plate 33. As is visible from Fig. 3, in the present example the wall 32 is typically formed of the distribution plate 33 surrounded by vacuum sealing 35. Moreover, Fig. 3 illustrates that in the present example the apertures 34 have equal spacings to each other, typically of about 10 mm to about 100 mm. Furthermore, the apertures 34 may be circular and may have a diameter of about 0.1 mm to 5 mm. Hence, the apertures 34 forming the reactive gas outlets may be arranged in a regular pattern, according to the present example in a pattern of apertures having equal distances. However, according to other examples of embodiments disclosed herein, the apertures forming the reactive gas outlets may have varying distances to each other, in order to achieve a desired, e.g. homogeneous, gas distribution across the substrate surface facing the distribution plate.

According to embodiments disclosed herein, the housing of the reactive gas distributor 30 comprises at least one material selected from the group consisting of quartz, aluminum, anodized aluminum, alumina, stainless steel, passivated stainless steel, SiO₂-coated stainless steel.

In the example illustrated in Fig. 1, the material of the distribution plate 33 provided in wall 32 typically includes quartz, and more typically consists of quartz. The other walls of the reactive gas distributor 30 may also include quartz as a material or may be formed of an aluminum containing material, such as Al₂O₃. In another variation, the walls of the reactive gas distributor 30, optionally except for the distribution plate 33, are formed of stainless steel having at the interior side linings or a shielding consisting of an aluminum containing material, the linings or the shielding optionally being exchangeable. Because of the specific materials of the interior walls and/or of the shielding, respectively, and since at least the distribution plate 33 includes or is formed of quartz, even aggressive reactive gases, e.g. oxygen-rich fluorine gases, may be filled in the reactive gas distributor 30 while affecting or damaging the inside walls thereof is avoided.

As is schematically shown in Fig. 1, in the present example of a reactive gas treatment system, the reactive gas distributor 30 is mounted at the opening 20 of vacuum chamber 12, the distribution plate 33 filling the opening 20 of the vacuum chamber 12. Thereby, the interior of the reactive gas distributor 30 is connected to the interior of the vacuum chamber 12 via the apertures 34 of the distribution plate 33. Furthermore, by mounting the reactive gas distributor 30 at opening 20, the platform 16 of the substrate support 14, and, hence, a substrate 18 placed thereon are positioned facing the reactive gas distributor 30.

Furthermore, in the present example of a reactive gas treatment system illustrated in Fig. 1, at flange 39 of the reactive gas distributor 30, a remote plasma source 50 is mounted in a vacuum tight manner. Plasma source 50 is connected to process gas sources (not shown) and a power supply (not shown). Plasma source 50 may be an inductively-coupled RF plasma source (e.g. 2 MHz) and typically produces a high-density-plasma that reacts on or dissociates process gas, in order to produce reactive species. The latter form a reactive gas flowing out of the source 50 through an opening 52 thereof.

According to an embodiment disclosed herein, a reactive gas treatment method for treating a substrate with a reactive gas comprises providing a substrate in a reactive gas treatment chamber, producing a reactive gas in a remote plasma source, directing the reactive gas through a reactive gas distributor into the reactive gas treatment chamber, the reactive gas distributor having a plurality of reactive gas outlets arranged in a pattern, and treating the substrate with the reactive gas.

In the following, an etching procedure for a pre-treatment of the surface of a substrate 18, e.g. an OLED substrate, using the reactive gas treatment system and the reactive gas distributor according to the examples of Figs. 1 to 3 is described. At first, the substrate 18 is provided at the platform 16 of substrate support 14, the substrate surface to be treated facing the reactive gas distributor 30. Then, a vacuum pressure of about 0.1 to about 5 mbar, typically about 1 mbar is established inside the reactive gas treating system by pumping. After that, the remote plasma source 50 is started and a process gas, in this example O₂ for the pre-treatment of the substrate 18, is introduced into the remote plasma source 50. Thereby, a gas of reactive oxygen species for treating the substrate 18 is produced. The reactive gas is released through aperture 52 of the remote plasma source 50 and flange 39 of the reactive gas distributor 30 into the interior space thereof. The reactive gas is spread inside the reactive gas distributor 30- and increases the pressure therein. The pressure, which is established inside the reactive gas distributor 30, depends on the gas flow from the remote plasma source into the gas distributor 30 and on the number and size of the apertures 34. The reactive gas passes through the apertures 34 into the vacuum chamber 12 towards the substrate 18 supported on the platform 16. Typically, the apertures 34 may have in sum a total flow rate of about 1000 sccm to about 7000 sccm (Standard Cubic Centimeters per Minute). Thereby, the reactive gas is distributed over the exposed substrate surface facing the distribution plate 33, and etching is performed for pre-treating the substrate 18.

As a result, across the substrate surface, which faces the distribution plate 33, an oxygen pressure distribution better than about ± 5 % may be achieved. Thereby, a desired etching effect for pre-treating the substrate 18 may be obtained. Moreover, over-etching of partial areas of the substrate surface may be avoided.

In order to change the reactive gas distribution across the substrate surface, the reactive gas distributor 30 may be provided with another distribution plate having a pattern of apertures, i.e. reactive gas outlets, adapted to the desired pressure distribution. As shown for instance in Fig. 4, in a variation of the above example, the wall 32 of the reactive gas distributor 30 may include a distribution plate 40 having apertures 42 arranged in a regular pattern different from the pattern of distribution plate 33. The distribution plate 40 according to Fig. 4 has a pattern of apertures 42 resulting in a greater number of apertures 42 in the peripheral regions of the distribution plate 40 as compared to the centre thereof. Hence, the flow of reactive gas out of the reactive gas distributor 30 may be adapted such that the pressures at the outer regions of the exposed substrate surface are adjusted to the pressures at the centre of the substrate surface to be treated. Thereby, a substantially even reactive gas distribution across the substrate surface facing the reactive gas distributor 30 may result, for instance a gas distribution with a homogeneity of about +/- 5 %. Furthermore, prevention of an over-etching of the centre of the substrate surface to be treated may be promoted. Alternatively, for providing a desired reactive gas distribution across the substrate surface, the diameter of some or all apertures 32 and/or 42 shown in Fig. 3 and 4, respectively, may be varied. E.g. the apertures 32 and 42 in the peripheral regions of the distribution plates 33 and 40, respectively, may have a greater diameter than the apertures 32 and 42 in the centre of the distribution plates 33 and 40, respectively, in order to adjust the pressures at the outer regions of the exposed substrate surface to the pressures at the centre of the substrate surface to be treated.

Moreover, the distribution plates 33 and 40 of above examples may contain quartz or may be formed of quartz which is substantially resistant to damage by reactive oxygen species. Therefore, it is avoided that the reactive oxygen species included in the reactive gas has a potentially detrimental effect on the material of the distribution plates.

As mentioned above, for pre-treating e.g. an OLED substrate, a reactive gas containing reactive oxygen species may be used, O₂ being a corresponding process gas to be introduced into the remote plasma source. Other typical process gases, which are suitable to produce reactive gases for pre-treatment of e.g. OLED substrates and which may be processed in the remote plasma source 50, are O₂/Ar-mixtures. For these cases a reactive gas distributor 30 including the distribution plates 33 or 40 of above examples may be suitable, since they include quartz. In case of reactive gases produced from process gases containing O₂ and fluorine, some or all walls of the reactive gas distributor 30 may be formed of aluminum or of an aluminum containing material, while the distribution plate 33 or 40 may include or consist of quartz. This material combination allows for using even aggressive oxygen and fluorine containing reactive gases in the reactive gas treatment system of the present examples, for instance in order to clean shadow masks used in the production of OLED devices.

Above examples of embodiments described herein allow for an installation of a reactive gas distributor between a remote plasma source and a process chamber in which a substrate to be treated is provided, although such an installation of a reactive gas distributor results in a longer path to travel by the reactive gas from the remote plasma source to the substrate to be treated. This effect is due to the specific materials combinations of the reactive gas distributor 30. These materials combinations reduce recombinations and reactions of the reactive species, which are contained in the reactive gas, at the surfaces of the reactive gas distributor 30. Therefore, the concentrations of the reactive gas species and, hence, the effectivity of the remote plasma source 50 are not reduced in spite of the additional surfaces presented by the reactive gas distributor 30 between the remote plasma source 50 and the process chamber 12. Simultaneously, the reactive gas is distributed, e.g. more evenly, across the substrate surface to be treated, thereby reducing or even preventing over-etching or excessive treatment of partial regions of the substrate. Moreover, in any of the embodiments disclosed herein the reactive gas distribution may be tailored as desired, e.g. by choosing an appropriate pattern and/or appropriate sizes of some or all of the reactive gas outlets. Consequently, when the reactive gas distributor according to embodiments disclosed herein is used in the manufacture of OLED devices, the production of OLEDs, which show an inhomogeneous performance due to an inhomogeneous reactive gas treatment, is avoided.

According to another embodiment, the housing of the reactive gas distributor may be provided inside of the reactive gas treatment chamber at an opening of the reactive gas treatment chamber, the reactive gas outlets being directed into the reactive gas treatment chamber, and the reactive gas inlet being fluidly connected to the remote plasma source which is provided outside of the reactive gas treatment chamber. In a modification of this embodiment, the reactive gas treatment chamber may further comprise a substrate support adapted for transporting the substrate to be etched continuously or discontinuously through the reactive gas treatment chamber.

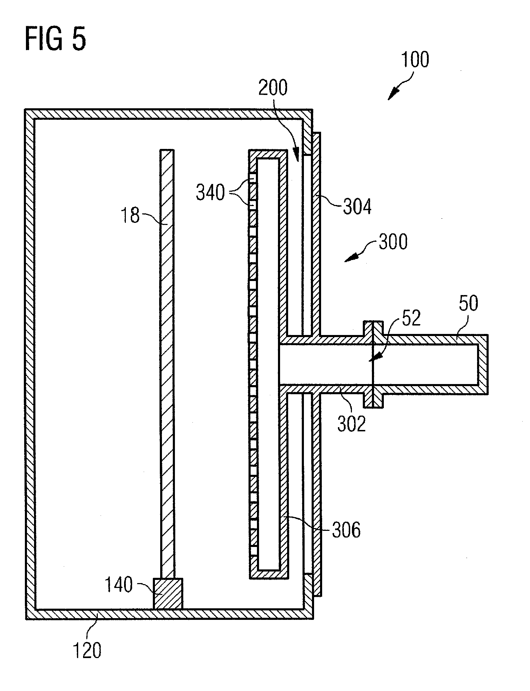

Fig. 5 illustrates an example of embodiments disclosed herein, directed to a reactive gas treatment system 100 for treating continuously or discontinuously conveyed plate-shaped substrates with a reactive gas. Such a reactive gas treatment system may for example be used in an OLED production installation, in which several vacuum compartments are located one after another, each compartment being for performing one process step. Examples of OLED process steps are reactive gas pre-treatment of an OLED substrate, physical vapor deposition (PVD) of organic materials for OLED devices, and reactive gas after-treatment of a vapor deposited OLED substrate. Each compartment may include process gas inlets and may be connected to a vacuum pump for evacuation. The compartments are connected to one another by means of openings, typically vacuum locks or airlocks, which may include one or more slit valves. A transport system for transporting the substrates along a path in front of devices performing the corresponding process steps, e.g. reactive gas treatment or PVD, and passing the substrates through the openings between the compartments is further provided.

In Fig. 5, as the reactive gas treatment chamber a compartment 120 including the reactive gas treatment system 100 is shown. The compartment 120 comprises a bottom wall, a top wall, a front wall (not shown), a rear wall (not shown) and two opposite sidewalls, the material of all walls being stainless steel, the compartment 120 being vacuum-tight. Through compartment 120 a plurality of substrates 18 may be continuously or discontinuously transported lengthwise. To this end, in the present example, the substrates are held in a substrate support 140 mounted at the bottom wall and being a transport system adapted to transport a plurality of substrates 18, the width of the substrates 18 being provided upright. The front wall includes a substrate feeding opening (not shown) and the rear wall includes a substrate discharge opening (not shown), the openings being designed as vacuum locks or airlocks, typically slit valves, for maintaining a vacuum in the coating chamber when feeding and discharging the substrates 18. The compartment 120 further has process gas inlets (not shown) and is connected to vacuum pumps (not shown) for establishing a vacuum of up to about 10⁻⁶ mbar. For reactive gas etching, suitable vacuum pressures may for example be in the range of about 0.1 to about 5 mbar, typically about 1 mbar.

One sidewall of compartment 120 includes an opening 200 which may be constructed e.g. as a flange or as an aperture adapted to receive a unit including a vacuum device for substrate processing. In the present example, the dimensions of the opening 200 typically substantially correspond to the dimensions of the substrate 18 to be treated. Alternatively, the dimensions of the opening 200 may be smaller or even greater than the substrate dimensions. A typical example of dimensions of a substrate which may be processed in the reactive gas treatment system of the present example are typically about 300 mm x about 400 mm, more typically about 750 mm x about 920 mm, that means the substrate may be a so called large area substrate. Hence, the dimensions of the opening 200 may be about 1 m². As will be understood by the skilled person, the dimensions of compartment 120 and of opening 200 may be adapted to the dimensions of the substrates to be processed therein.

According to one example of embodiments disclosed herein, a reactive gas distributor for a reactive gas treatment system may comprise: a housing, a reactive gas inlet provided at one side of the housing and fluidly connectable to a remote plasma source, and a plurality of reactive gas outlets at another side of the housing and arranged in a pattern.

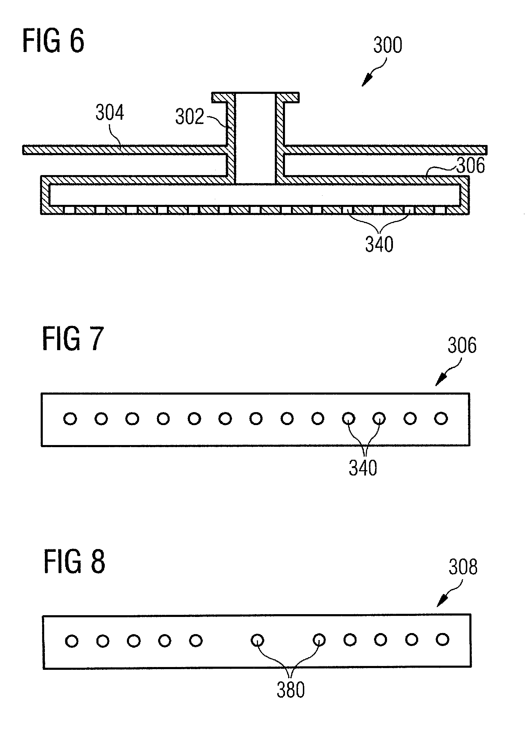

In the present example of a reactive gas treatment system according to embodiments disclosed herein, at opening 200 a reactive gas distributor 300 is mounted in a vacuum-tight way. Fig. 6 is an enlarged cross-sectional view of the reactive gas distributor 300 shown in Fig. 5. Reactive gas distributor 300 typically includes a vacuum flange 302 provided in a vacuum-compatible fitting collar 304, which may itself be a vacuum flange and encompasses vacuum flange 302. The dimensions of the fitting collar 304 are adapted to the dimensions of opening 200 provided in the compartment 120, such that fitting collar 304 may be mounted at opening 200. One end of vacuum flange 302 is adapted to receive a remote plasma source and serves as reactive gas inlet. The other end of vacuum flange 302 typically includes a distribution tube 306 having in a centre line along the length thereof a row of apertures 340 as reactive gas outlets, the row being typically provided in a region of the distribution tube opposite to vacuum flange 302.

The dimensions of the reactive gas distributor 300 may be such that the dimensions of the distribution tube 306 correspond or are adapted to the width of the substrates to be treated with a reactive gas. E.g. according to a typical example, the width of the substrates may be in a range of about 0.3 m to about 0.9 m. Hence, the distribution tube 306 may typically have a length of about 0.3 m to about 1 m. In a typical example, for a substrate of 0.9 m width, the distribution tube 306 may have a length of about 1 m. The diameter of the distribution tube may for example be in a range of about 0.02 m to about 0.15 m.

Fig. 7 shows schematically a view of the reactive gas distributor 300 according to the present example, illustrating a side view of the gas distributor, which is a plan view of the region of the distribution tube 306, which includes the row of apertures 340. As is visible from Fig. 7, in the present example the plurality of apertures 340 have spacings typically of about 0.5 mm to about 5 mm. Furthermore, in the present example the apertures 34 are typically formed of nozzles. Alternatively, each aperture 340 may include an injector. According to examples of embodiments disclosed herein, the apertures forming the reactive gas outlets may have equal or varying distances to each other, in order to achieve a desired, e.g. homogeneous, gas distribution across the substrate surface facing the distribution tube.

According to embodiments disclosed herein, the housing of the reactive gas distributor 300 comprises at least one material selected from the group consisting of quartz, aluminum, anodized aluminum, alumina, stainless steel, passivated stainless steel, SiO₂-coated stainless steel.

In the example illustrated in Fig. 5, for applications using a reactive gas containing an oxygen species, the walls of the distribution tube 306 typically include quartz, and more typically consist of quartz. The other walls of the reactive gas distributor 300 may also comprise quartz as a material or may be formed of an aluminum containing material, such as Al₂O₃. In another variation of the present example, which may be utilized for reactive gases containing fluorine species, the walls of the reactive gas distributor 300 and the distribution tube 306 may be formed of aluminum or anodized aluminum. Alternatively, in case of treatments with a reactive gas which contains reactive oxygen species, stainless steel passivated by a coating, such as SiO₂, may be used as wall material of the reactive gas distributor and/or the distribution tube thereof. Furthermore, the wall may be formed of stainless steel having at the interior side linings or a shielding consisting of a quartz and/or aluminum containing material or consisting of stainless steel passivated by a coating, such as SiO₂, the linings or the shielding optionally being exchangeable. Because of the specific materials of the interior walls, even aggressive reactive gases, e.g. oxygen-rich fluorine gases, may be filled in the reactive gas distributor 300 without affecting or damaging the inside walls thereof.

As is schematically shown in Fig. 5, in the present example of a reactive gas treatment system, the fitting collar 304 of reactive gas distributor 300 is mounted at opening 200 of compartment 120 in a vacuum tight way. The distribution tube 306 is positioned in compartment 120 such that the row of apertures 340 is directed towards the transport path and across the upright width of the substrates 18 transported through compartment 120. Thereby, the interior of the reactive gas distributor 300 is connected to the interior of compartment 120 via the apertures 34 of the distribution tube 306.

Moreover, in the present example of a reactive gas treatment system illustrated in Fig. 5, the reactive gas distributor 300 has a remote plasma source 50 mounted at the free end of vacuum flange 302 in a vacuum tight manner. Plasma source 50 is connected to process gas sources (not shown) and a power supply (not shown) and may be an inductively-coupled RF plasma source operating at e.g. 2 to 3 MHz. It typically produces a high-density-plasma that dissociates process gas into reactive species which flow out of the source 50 through opening 52, which in the present example is connected to flange 302 of the reactive gas distributor 300.

According to an embodiment disclosed herein, a reactive gas treatment method for treating a substrate with a reactive gas comprises providing a substrate in a reactive gas treatment chamber, producing a reactive gas in a remote plasma source, directing the reactive gas through a reactive gas distributor into the reactive gas treatment chamber, the reactive gas distributor having a plurality of reactive gas outlets arranged in a pattern, and treating the substrate with the reactive gas.

In order to perform an etching procedure using the reactive gas treatment system and the reactive gas distributor according to the examples described above with reference to Fig. 5 to 7, a vacuum pressure of about 1 mbar inside the reactive gas treating system 100 is established by pumping. After that, a process gas is introduced into the operating remote plasma source 50 which produces the reactive species for treating the substrate 18. One of the substrates 18 is fed into the compartment 120, is provided having its width positioned upright on the substrate support 140 and is continuously transported in front of the distribution tube 306 of reactive gas distributor 300. The gas of reactive species is released through aperture 52 of the remote plasma source 50 and flange 302 of the reactive gas distributor 300 into the distribution tube 306. The gas of reactive species is spread inside the distribution tube 306. The pressure, which is established inside the distribution tube 306, depends on the gas flow from the remote plasma source 50 into the distribution tube 306 and on the number and size of the apertures 340. Typically, the apertures 340 may have in sum a total flow rate of about 1000 sccm to about 7000 sccm. The reactive gas travels towards the substrate 18 being transported in front of the reactive gas distributor 300. Thereby, the reactive gas is distributed across the width of the exposed substrate surface facing the distribution tube 330, and etching is performed for treating the substrate 18. Hence, a desired etching effect, in order to for instance pre-treat or after-treat an OLED substrate, may be achieved. Furthermore, since the nozzle of each aperture 340 releases reactive gas at the same velocity and since the apertures 340 have appropriate equal or varying spacings, a substantially even reactive gas distribution across the part of the substrate surface facing the reactive gas distributor 300 may result. Therefore, prevention of an over-etching of the centre of the substrate surface to be treated may be promoted.

In order to change the reactive gas distribution across the substrate surface, the reactive gas distributor 300 may be provided with another distribution tube 308 having a row of apertures 340 adapted to the desired gas distribution. As shown in Fig. 8, in the distribution tube 308 apertures 340 in the centre of the row may have for example greater spacings as compared to the apertures 340 located in the ends of the distribution tube. Hence, the reactive gas flow out of the reactive gas distributor 300 may be adapted such that the flow towards the outer regions of the substrate surface and the flow towards the centre of the substrate surface are modified as desired. In a further variation of the reactive gas distributor, a double row of apertures functioning as reactive gas outlets of the distribution tube may be provided. Alternatively or in addition to modifying the pattern of the reactive gas outlets of the reactive gas distributor, in order to change the reactive gas distribution across the substrate surface, the velocities of the released reactive gas may be varied for some or all of the nozzles included in the apertures 340. Moreover, the length of the distribution tube may be varied, e.g. increased or reduced, in order to provide a variation of gas distribution across the width of the substrates 18. Furthermore, a plurality of identical or non-identical distribution tubes may be provided in compartment 120 side by side, using a gas distributor having a plurality of distribution tubes, or using a plurality of gas distributors.

In addition, the distribution tube 306 of the present example may contain quartz or may be formed of quartz which is substantially resistant to damage by reactive oxygen species. Therefore, it is avoided that the reactive oxygen species included in the reactive gas has a potentially detrimental effect on the material of the distribution tube.

As mentioned above, for pre-treating an OLED substrate, a reactive gas containing reactive oxygen species may be used, O₂ being the corresponding process gas to be introduced into the remote plasma source. Other typical process gases, which are suitable to produce reactive gases for pre-treatment of OLED substrates and which may be processed in the remote plasma source 50, are O₂/Ar-mixtures. For these cases a reactive gas distributor 300 including a distribution tube consisting of quartz may be used. Alternatively, in case of treatments with a reactive gas containing reactive oxygen species, stainless steel passivated at least at the inside walls by a coating, such as SiO₂, may be used as a material for the reactive gas distributor. In case of reactive gases gained from process gases containing fluorine, some or all walls or at least some or all inside walls of the reactive gas distributor 300 may be formed of aluminum or of an aluminum containing material. The latter materials allow for using even aggressive oxygen and fluorine containing reactive gases in the reactive gas treatment system of the present examples, for instance in order to clean shadow masks used in the production of OLED devices.

The examples described above with reference to Fig. 5 to 8 are directed to an installation of a reactive gas distributor between a remote plasma source and a process chamber, in which a substrate to be treated is transported continuously or discontinuously, e.g. in an in-line compartment of an OLED production installation. The reactive gas distributor may be installed therein without reducing the effectivity of the remote plasma source, although resulting in a longer path to travel by the reactive gas from the remote plasma source to the substrate to be treated. This effect is due to the specific materials combinations of the reactive gas distributor 300. These materials combinations reduce recombination and reactions of the reactive species, which are contained in the reactive gas, at the inside surfaces of the reactive gas distributor 300. Therefore, the concentrations of the reactive gas species and, hence, the effectivity of the remote plasma source 50 are not reduced in spite of the additional surfaces presented by the reactive gas distributor 300 between the remote plasma source 50 and the compartment 120. Simultaneously, the reactive gas distribution may be tailored as desired, e.g. by choosing an appropriate pattern and/or appropriate flow rates of some or all of the reactive gas outlets or nozzles and/or an appropriate total flow rate of the sum of all gas outlets or nozzles, respectively. For instance, the reactive gas may be distributed across the substrate surface to be treated more evenly. Thereby, a gas distribution with a homogeneity of about +/- 5 % may be achieved. Moreover, over etching or excessive treatment of partial regions of the substrate may be reduced or even prevented. Consequently, when the reactive gas distributor according to embodiments disclosed herein is used in the manufacture of OLED devices, the production of OLEDs, which show an inhomogeneous performance due to an inhomogeneous reactive gas treatment, is avoided.

An embodiment is directed to a reactive gas distributor for a reactive gas treatment system, comprising: a housing, a reactive gas inlet provided at one side of the housing and fluidly connectable to a remote plasma source, and a plurality of reactive gas outlets at another side of the housing and arranged in a pattern.

In a modification of above embodiment, the housing comprises at least one material selected from the group consisting of quartz, aluminum, anodized aluminum, alumina, stainless steel, passivated stainless steel, SiO₂-coated stainless steel.

In a modification of any of above embodiment and modification thereof, at least the side of housing, which comprises the reactive gas outlets, is made of quartz.

In a modification of any of above embodiment and modifications thereof, the housing is adapted to be provided outside of a reactive gas treatment chamber at an opening of the reactive gas treatment chamber, the outlets being directed into the reactive gas treatment chamber.

In a modification of any of above embodiment and modifications thereof, the housing is adapted to be provided inside of a reactive gas treatment chamber at an opening of the reactive gas treatment chamber, the reactive gas outlets being directed into the reactive gas treatment chamber, and the reactive gas inlet being fluidly connected to the opening of the reactive gas treatment chamber.

In a modification of any of above embodiment and modifications thereof, the reactive gas outlets are selected from the group consisting of openings having a diameter of 0.5 mm to 5 mm , and nozzles having in sum a total flow rate of 1000 sccm to 7000 sccm (Standard Cubic Centimeters per Minute).

In a modification of any of above embodiment and modifications thereof, the pattern of the reactive gas outlets is selected from the group consisting of a regular pattern, a pattern having equal distances between the reactive gas outlets in the range of 10 mm to 100 mm, and a pattern having varying distances between the reactive gas outlets in the range of 10 mm to 100 mm.

In a modification of any of above embodiment and modifications thereof, the reactive gas outlets are provided in a distribution tube or in a distribution plate.

In a further embodiment, a reactive gas treatment system comprises a reactive gas treatment chamber, a reactive gas distributor and a remote plasma source, a reactive gas distributor being provided at the reactive gas treatment chamber, the reactive gas distributor comprising: a housing, a reactive gas inlet provided at one side of the housing and fluidly connected to the remote plasma source, and a plurality of reactive gas outlets at another side of the housing and arranged in a pattern. Typically, the reactive gas outlets may be directed into the reactive gas treatment chamber.

In a modification of above further embodiment, the housing of the reactive gas distributor is provided outside of the reactive gas treatment chamber at an opening of the reactive gas treatment chamber, the reactive gas outlets being directed into the reactive gas treatment chamber, the reactive gas treatment chamber optionally further comprising a substrate support adapted to stationary provide the substrate to be etched in the reactive gas treatment chamber.

In another modification of above further embodiment, the housing of the reactive gas distributor is provided inside of the reactive gas treatment chamber at an opening of the reactive gas treatment chamber, the reactive gas outlets being directed into the reactive gas treatment chamber, and the reactive gas inlet being fluidly connected to the remote plasma source which is provided outside of the reactive gas treatment chamber, the reactive gas treatment chamber optionally further comprising a substrate support adapted for transporting the substrate to be etched continuously or discontinuously through the reactive gas treatment chamber.

In a modification of any of above further embodiment and modifications thereof, the reactive gas distributor may be a reactive gas distributor wherein the housing comprises at least one material selected from the group consisting of quartz, aluminum, anodized aluminum, alumina, stainless steel, passivated stainless steel, SiO₂-coated stainless steel.

In a modification of any of above further embodiment and modifications thereof, the reactive gas distributor may be a reactive gas distributor wherein at least the side of housing, which comprises the reactive gas outlets, is made of quartz.

In a modification of any of above further embodiment and modifications thereof, the reactive gas distributor may be a reactive gas distributor wherein the reactive gas outlets are selected from the group consisting of openings having a diameter of 0.5 mm to 5 mm, nozzles having in sum a total flow rate of 1000 sccm to 7000 sccm , and openings having a pattern of the reactive gas outlets being selected from the group consisting of a regular pattern, a pattern having equal distances between the reactive gas outlets in the range of 10 mm to 100 mm, and a pattern having varying distances between the reactive gas outlets in the range of 10 mm to 100 mm.

In a modification of any of above further embodiment and modifications thereof, the reactive gas distributor may be a reactive gas distributor wherein the housing is adapted to be provided outside of a reactive gas treatment chamber at an opening of the reactive gas treatment chamber, the outlets being directed into the reactive gas treatment chamber.

According to a yet further embodiment, a reactive gas treatment method for treating a substrate with a reactive gas comprises providing a substrate in a reactive gas treatment chamber, producing a reactive gas in a remote plasma source, directing the reactive gas through a reactive gas distributor into the reactive gas treatment chamber, the reactive gas distributor having a plurality of reactive gas outlets arranged in a pattern, and treating the substrate with the reactive gas.

In a modification of above yet further embodiment, in the step of directing the reactive gas is directed through a reactive gas distributor comprising: a housing, and a reactive gas inlet provided at one side of the housing and fluidly connectable to a remote plasma source, the plurality of reactive gas outlets being provided at another side of the housing.

In a modification of any of above yet further embodiment and modification thereof, the housing comprises at least one material selected from the group consisting of quartz, aluminum, anodized aluminum, alumina, stainless steel, passivated stainless steel, SiO₂-coated stainless steel.

In a modification of any of above yet further embodiment and modifications thereof, at least the side of housing, which comprises the reactive gas outlets, is made of quartz.

In a modification of any of above yet further embodiment and modifications thereof, the housing is adapted to be provided outside of a reactive gas treatment chamber at an opening of the reactive gas treatment chamber, the outlets being directed into the reactive gas treatment chamber.

In a modification of any of above yet further embodiment and modifications thereof, the housing is adapted to be provided inside of a reactive gas treatment chamber at an opening of the reactive gas treatment chamber, the reactive gas outlets being directed into the reactive gas treatment chamber, and the reactive gas inlet being fluidly connected to the opening of the reactive gas treatment chamber.

In a modification of any of above yet further embodiment and modifications thereof, the reactive gas outlets are selected from the group consisting of openings having a diameter of 0.5 mm to 5 mm, and nozzles having in sum a total flow rate of 1000 sccm to 7000 sccm.

In a modification of any of above yet further embodiment and modifications thereof, the pattern of the reactive gas outlets is selected from the group consisting of a regular pattern, a pattern having equal distances between the reactive gas outlets in the range of 10 mm to 100 mm, and a pattern having varying distances between the reactive gas outlets in the range of 10 mm to 100 mm.

In a modification of any of above yet further embodiment and modifications thereof, the reactive gas outlets are provided in a distribution tube or in a distribution plate.

In a modification of any of above yet further embodiment and modifications thereof, in the step of providing a substrate the substrate is stationary provided in the treatment chamber or is transported continuously or discontinuously through the treatment chamber.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A reactive gas distributor for a reactive gas treatment system, comprising:
a housing,
a reactive gas inlet provided at one side of the housing and fluidly connectable to a remote plasma source, and
a plurality of reactive gas outlets at another side of the housing and arranged in a pattern.

2. The reactive gas distributor of claim 1, wherein the housing comprises at least one material selected from the group consisting of quartz, aluminum, anodized aluminum, alumina, stainless steel, passivated stainless steel, SiO₂-coated stainless steel.

3. The reactive gas distributor of claim 1 or 2, wherein at least the side of housing, which comprises the reactive gas outlets, is made of quartz.

4. The reactive gas distributor of any of claims 1 to 3, wherein the housing is adapted to be provided outside of a reactive gas treatment chamber at an opening of the reactive gas treatment chamber, the outlets being directed into the reactive gas treatment chamber.

5. The reactive gas distributor of any of claims 1 to 3, wherein the housing is adapted to be provided inside of a reactive gas treatment chamber at an opening of the reactive gas treatment chamber, the reactive gas outlets being directed into the reactive gas treatment chamber, and the reactive gas inlet being fluidly connected to the opening of the reactive gas treatment chamber.

6. The reactive gas distributor of any of claims 1 to 5, wherein the reactive gas outlets are selected from the group consisting of openings having a diameter of 0.5 mm to 5 mm, and nozzles having in sum a total flow rate of 1000 sccm to 7000 sccm.

7. The reactive gas distributor of any of claims 1 to 6, wherein the pattern of the reactive gas outlets is selected from the group consisting of a regular pattern, a pattern having equal distances between the reactive gas outlets in the range of 10 mm to 100 mm, and a pattern having varying distances between the reactive gas outlets in the range of 10 mm to 100 mm.

8. A reactive gas treatment system, comprising
a reactive gas treatment chamber, a reactive gas distributor and a remote plasma source,
a reactive gas distributor being provided at the reactive gas treatment chamber, the reactive gas distributor comprising:
a housing,
a reactive gas inlet provided at one side of the housing and fluidly connected to the remote plasma source, and
a plurality of reactive gas outlets at another side of the housing and arranged in a pattern.

9. The reactive gas treatment system according to claim 8, wherein
the housing of the reactive gas distributor is provided outside of the reactive gas treatment chamber at an opening of the reactive gas treatment chamber, the reactive gas outlets being directed into the reactive gas treatment chamber,
the reactive gas treatment chamber optionally further comprising a substrate support adapted to stationary provide the substrate to be etched in the reactive gas treatment chamber.

10. The reactive gas treatment system according to claim 8, wherein
the housing of the reactive gas distributor is provided inside of the reactive gas treatment chamber at an opening of the reactive gas treatment chamber, the reactive gas outlets being directed into the reactive gas treatment chamber, and the reactive gas inlet being fluidly connected to the remote plasma source which is provided outside of the reactive gas treatment chamber,
the reactive gas treatment chamber optionally further comprising a substrate support adapted for transporting the substrate to be etched continuously or discontinuously through the reactive gas treatment chamber.

11. The reactive gas treatment system according to any of claims 8 to 10, the reactive gas distributor being a reactive gas distributor according to any of claims 2, 3, 6 and 7.

12. A reactive gas treatment method for treating a substrate with a reactive gas, comprising
providing a substrate in a reactive gas treatment chamber,
producing a reactive gas in a remote plasma source,
directing the reactive gas through a reactive gas distributor into the reactive gas treatment chamber, the reactive gas distributor having a plurality of reactive gas outlets arranged in a pattern, and
treating the substrate with the reactive gas.

13. The reactive gas treatment method according claim 12, wherein in the step of directing the reactive gas is directed through a reactive gas distributor according to any of claims 1 to 7.

14. The reactive gas treatment method according to claim 12 or 13, wherein in the step of providing a substrate the substrate is stationary provided in the treatment chamber or is transported continuously or discontinuously through the treatment chamber.

15. Use of a reactive gas distributor according to any of claims 1 to 7 in a coating apparatus for the production of OLED devices.

16. Use of a reactive gas treatment system according to any of claims 8 to 11 in a coating apparatus for the production of OLED devices.
